# EUROPEAN PATENT SPECIFICATION

(11) **EP 3 884 242 B1**
(45) Date of publication and mention of the grant of the patent: **12.06.2024**
(21) Application number: 18940640.8
(22) Date of filing: 20.11.2018
(51) Int. Cl.: G01D 21/02, G01D 11/24, G01K 1/08, G01K 1/14, G01R 19/00, G01R 31/69, H02B 13/035

(54) **APPARATUS FOR MONITORING TEMPERATURE AND VOLTAGE OF CABLE JOINT OF CABLE CONNECTED TO GAS INSULATED SWITCHGEAR, AND ASSOCIATED MANUFACTURING METHOD**
VORRICHTUNG ZUR ÜBERWACHUNG DER TEMPERATUR UND SPANNUNG EINER KABELVERBINDUNG EINES MIT EINER GASISOLIERTEN SCHALTANLAGE VERBUNDENEN KABELS UND ZUGEHÖRIGES HERSTELLUNGSVERFAHREN
APPAREIL PERMETTANT DE SURVEILLER LA TEMPÉRATURE ET LA TENSION D'UNE JONCTION DE CÂBLES D'UN CÂBLE CONNECTÉ À UN APPAREILLAGE DE COMMUTATION À ISOLATION GAZEUSE ET PROCÉDÉ DE FABRICATION ASSOCIÉ

(43) Date of publication of application: 29.09.2021
(73) Proprietor: ABB Schweiz AG, 5400 Baden (CH)
(72) Inventor: XU, Baokun, Beijing 101102 (CN); ZHUANG, Genhuang, Xiamen, Fujian 361008 (CN); ZHUANG, Zhijian, Xiamen, Fujian 361021 (CN)
(74) Representative: Zimmermann & Partner Patentanwälte mbB
(86) International application number: PCT/CN2018/116423
(87) International publication number: WO 2020/102973

(56) References cited:
- CN-A- 102 207 406
- CN-A- 103 376 170
- CN-A- 103 575 325
- CN-A- 104 132 746
- CN-U- 202 651 537
- US-A1- 2015 204 753
- US-A1- 2017 016 936

## Description

### FIELD

Embodiments of present disclosure generally relate to the field of electrical equipment, and more particularly, to an apparatus for monitoring both temperature and voltage of a cable joint of a cable connected to gas insulated switchgear (GIS), and to associated manufacturing method.

### BACKGROUND

Gas insulated switchgear (GIS) is widely used in high-voltage distribution application. In use, a cable is typically connected to the GIS through a cable joint so as to transmit electrical power to the GIS. If the connection between the cable joint and the GIS is poor, a large contact resistance may occur at the cable joint. Therefore, a temperature of the cable joint may increase greatly when a current flows in the cable, and thus needs to be monitored.

Furthermore, voltage presence indication system (VPIS) is also an important element for the GIS to indicate the presence of voltage at the cable joint. In majority of current designs of GIS, there is only one port for either VPIS contacting or temperature monitoring device contacting. In this case, if this port is occupied by VPIS, the temperature monitoring function can no longer be supported. Likewise, if the port is occupied by the temperature monitoring device, there is no extra space for any VPIS to be installed to the cable joint. CN202651537U describes a cable plug with temperature detection; US20170016936A1 describes an electrical sensor. In particular, US 2017/016936 A1 discloses a probe for monitoring temperature and voltage of a high-tension cable or cable joint. The probe includes a voltage sensor for sensing the voltage on the cable. The probe also includes a temperature sensor included in a plug-in device.

Therefore, there is a need for a new solution for monitoring both temperature and voltage of the cable joint, while keeping the current design of electric bushing unchanged.

### SUMMARY

According to the present invention, an apparatus according to claim 1 is provided.

In some embodiments, the apparatus further comprises: a shielding layer surrounding wires between the temperature sensor and the processing circuitry, the shielding layer being coupled to the ground terminal of the temperature sensor.

In some embodiments, the apparatus further comprises: a transient voltage suppressor coupled between the ground terminal of the temperature sensor and a power supply of the temperature sensor to electrically shield the processing circuitry from the detected voltage of the adaptor.

In some embodiments, the adaptor, when coupled to the cable socket, is situated at a mounting outside the cable socket.

In some embodiments, the adaptor comprises: a first part coupled to the cable socket at the mounting surface; and a second part adapted to accommodate the temperature sensor and a connecting port to the voltage indicating device.

In some embodiments, the cable socket comprises a threaded hole at the mounting surface, and the first part is a threaded rot adapted to be inserted into the threaded hole.

In some embodiments, the second part comprises: a receiving hole in which the temperature sensor is arranged and sealed by pouring sealant, and an end surface to couple the connecting port.

According to the invention, a method according to claim 8 is provided.

In some embodiments, the method further comprises: surrounding, by a shielding layer, wires between the temperature sensor and the processing circuitry; and coupling the shielding layer to the ground terminal of the temperature sensor.

In some embodiments, the electrically shielding the processing circuitry comprises: coupling a transient voltage suppressor between the ground terminal of the temperature sensor and a power supply of the temperature sensor.

In some embodiments, the adaptor comprises: a first part coupled to the cable socket at the mounting surface; and a second part adapted to accommodate the temperature sensor and a connecting port to the voltage indicating device.

In some embodiments, the second part comprises a receiving hole, wherein the method further comprises: arranging the temperature sensor in the receiving hole; sealing the receiving hole by pouring sealant; and coupling the connecting port to an end surface of the second part.

In a third aspect, a gas insulated switchgear comprising the apparatus according to the first aspect.

According to various embodiments of the present disclosure, the temperature sensor is arranged in the adaptor coupled to the cable socket of the switchgear and the temperature of the cable joint may be determined based on the temperature of the adaptor. Since the location of the adaptor is close to the cable joint, the temperature of the cable joint may be determined conveniently and precisely. Moreover, through the adaptor, the temperature sensor is easy to be installed and maintained.

### DESCRIPTION OF DRAWINGS

Through the following detailed descriptions with reference to the accompanying drawings, the above and other objectives, features and advantages of the example embodiments disclosed herein will become more comprehensible. In the drawings, several example embodiments disclosed herein will be illustrated in an example and in a non-limiting manner, wherein:
Fig. 1 schematically illustrates a gas insulated switchgear according to an example embodiment;
Fig. 2 schematically illustrates an apparatus for monitoring temperature and voltage of a cable joint according to an example embodiment;
Fig. 3 schematically illustrates an example arrangement of the apparatus for monitoring the temperature and voltage of the cable joint relative to a cable socket;
Fig. 4 schematically illustrates another example arrangement of the apparatus for monitoring the temperature and voltage of the cable joint relative to a cable socket;
Fig. 5 illustrates an example shielding mechanism applied on the apparatus for monitoring the temperature and the voltage of the cable joint according to an embodiment of the present disclosure;
Fig. 6 illustrates another example shielding mechanism according to an embodiment of the present disclosure;
Fig. 7 is a schematic cross sectional view of a cable socket according to an embodiment of the present disclosure;
Fig. 8 illustrates a cross-sectional view of the cable socket 31 as shown in Fig. 3, but with no adaptor 101 attached thereon; and
Fig. 9 illustrates an apparatus according to an embodiment of the disclosure, with a different type of adaptor from the adaptor as shown in Fig. 5;
Fig. 10 illustrates an apparatus according to an embodiment of the disclosure, with a different type of adaptor from the adaptor as shown in Fig. 6;
Fig. 11 illustrates an example arrangement of the apparatus as shown in Fig. 9 and Fig. 10 relative to the cable socket as shown in Fig. 4; and
Fig. 12 is a flow chart of a method for manufacturing the apparatus for monitoring a temperature and voltage of a cable joint of a cable connected to the switchgear according to embodiments of the present disclosure.

Throughout the drawings, the same or similar reference symbols are used to indicate the same or similar elements.

### DETAILED DESCRIPTION OF EMBODIEMTNS

As used herein, the term "includes" and its variants are to be read as open terms that mean "includes, but is not limited to." The term "based on" is to be read as "based at least in part on." The term "one embodiment" and "an embodiment" are to be read as "at least one embodiment." The term "another embodiment" is to be read as "at least one other embodiment." The terms "first," "second," and the like may refer to different or same objects. Other definitions, explicit and implicit, may be included below. A definition of a term is consistent throughout the description unless the context clearly indicates otherwise.

As discussed above, the cable used in the current GIS is an all-insulation cable and there is only one port for either temperature sensor or voltage detector to be installed to the cable joint. Therefore, it is always challenging to connect the two types of sensors to the single port simultaneously. Moreover, due to the fact that GIS is normally operated in a high-voltage environment, while the temperature sensor and the processing circuitry normally operates in the low-voltage environment, how to reduce the impact of the induced high voltage (from the adaptor) to the processing circuitry is also challenging.

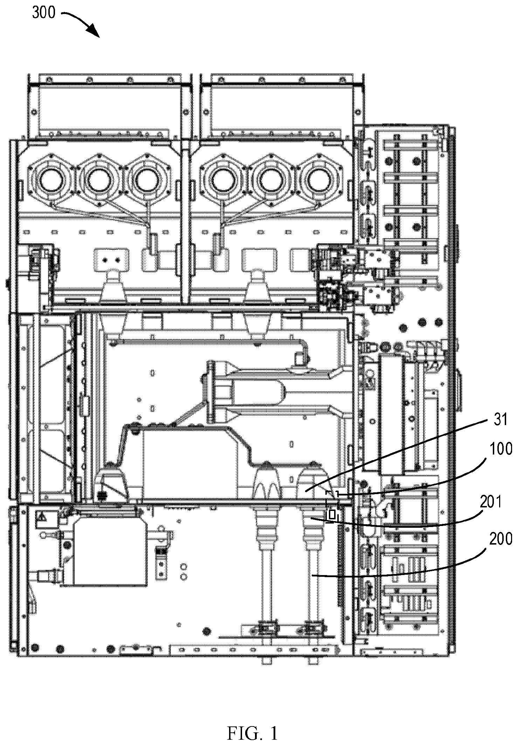

According to embodiments of the present disclosure, a complex-function adaptor (or a complex-function joint) which supports both temperature measurement and voltage detecting simultaneously is provided. In addition, by means of the additionally applied shielding mechanisms, the impact of induced voltage to the processing circuitry can be reduced. Hereinafter, the principles of the present disclosure will be described in detail with reference to Figs. 1-12.

Fig. 1 schematically illustrates a gas insulated switchgear 300 according to an example embodiment. As shown, the switchgear 300 includes a cable socket 31. A cable 200 may be connected to the cable socket 31 through a cable joint 201 so as to transmit electrical power to the switchgear 300. In use, if the connection between the cable joint 201 and the cable socket 31 is poor, a large contact resistance may occur at the cable joint 201. In this situation, a temperature of the cable joint 201 may increase greatly when a current flows in the cable 200.

Moreover, a high voltage up to several hundred volts may also be present at the cable joint 201. Therefore, a voltage presence indication system (VPIS) is another important element for the GIS to indicate the presence of high voltage at the cable joint 201.

In order to timely capture the temperature change of the cable joint 201 and meanwhile indicating the voltage presence, the switchgear 300 may further include an apparatus 100 for monitoring both the temperature and the voltage of the cable joint 201.

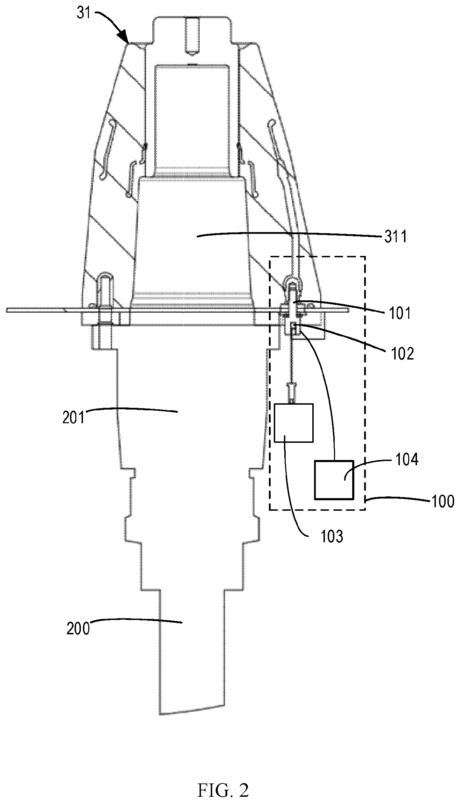

Hereinafter, example configurations of the apparatus 100 will be described in detail with respect to Figs. 2-11.

Fig. 2 schematically illustrates an apparatus 100 for monitoring the temperature and voltage of a cable joint 201 according to the present invention. The apparatus 100 comprises an adaptor 101, a temperature sensor 102, a processing circuitry 103, and a voltage detector 104. The adaptor 101 is adapted to be coupled to the cable socket 31. Further, the adaptor 101 can be made of semiconductor or metal, and the metal includes but not limited to brass and aluminum. In some embodiments, the brass is selected for the material of adaptor 101 considering its good heat conducting performance and low cost.

As further illustrated in Fig. 2, the temperature sensor 102 is arranged in the adaptor 101 and configured to detect the temperature of the adaptor 101. The processing circuitry 103 (for example, a printed circuit board, "PCB") is configured to determine the temperature of the cable joint 201 based on the detected temperature of the adaptor 101. The voltage detector 104, such as, VPIS, is coupled to the adaptor 101 and configured to detect the voltage of the adaptor 101.

As discussed above, the voltage detector or VPIS herein is not used to determine the "exact" voltage level at the adaptor 101. Rather, it is only used to indicate whether there is voltage present at the adaptor 101 or at the cable joint 201.

For instance, in some application scenarios, when the voltage level is lower than a first predetermined threshold (i.e., the voltage level is low enough), the voltage detector 104 may not provide any visual indication. But when the voltage level is higher than the first threshold (i.e., the voltage level is high enough), the voltage detector 104 may, for example, flash with a relatively low frequency in order to indicate a relatively low voltage level. Further, when the voltage level is even higher than a second threshold (the second threshold is higher than the first threshold), the voltage detector 104 may begin to flash with a relatively high frequency to indicate a relatively high voltage level.

Alternatively, or in addition, the voltage detector may provide an acoustic indication (such as, alarm) to the user, for example, by means of the amplitude and/or frequency of the alarm.

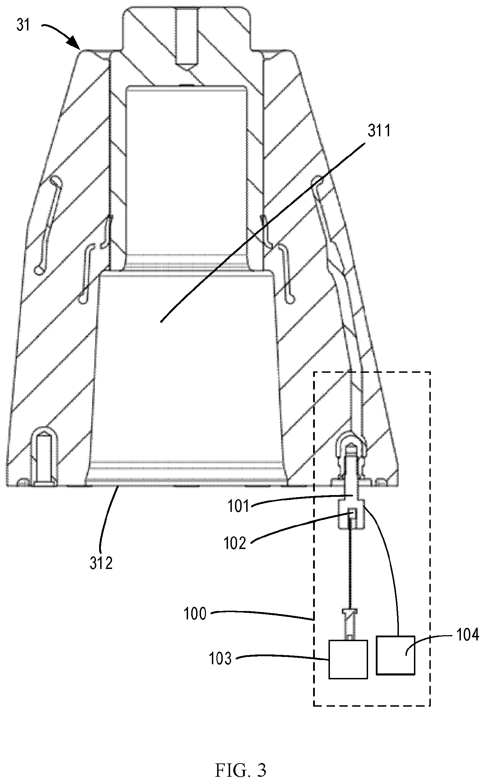

Fig. 3 schematically illustrates an example arrangement of the apparatus 100 relative to the cable socket 31. As illustrated in Fig. 3, the adaptor 101, when coupled to the cable socket 31, is situated at a mounting surface 312 of the cable socket 31. A mounting hole 311 for connecting the cable joint 201 is also provided on the same mounting surface 312. As shown, along the mounting surface 312, the adaptor 101 is spaced from the mounting hole 311 by a distance.

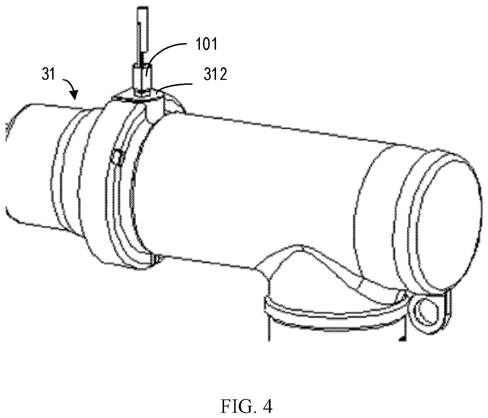

In the example as shown in Fig. 3, the cable socket 31 is an external cable socket 31. However, it is to be understood that the application of the apparatus 100 according to various embodiments of the present disclosure is not limited to the external cable socket 31 as shown in Fig. 3. Rather, the adaptor 101 can also be applied on an internal cable socket 31 as shown in Fig. 4. Also, it is to be understood that the present disclosure does not seek to limit the material, form, or design style or the cable socket. Rather, any cable sockets that can provide the port and support the operation of the installed apparatus 100 should all fall within the protection scope of the present disclosure.

With the proposed solution, VPIS and temperature sensor now can be both coupled to the cable socket 31 via a single complex-functional adaptor 101. In this way, both temperature and voltage can be measured simultaneously in a non-intrusive way, while the current design of cable socket is kept unchanged. Therefore, compared with those conventional solutions, the overall cost of the apparatus 100 is reduced. Further, such complex-functional adaptor 101 will be suitable for both new installation and retrofit applications. Moreover, since the location of the adaptor 101 is close to the cable joint 201, the temperature of the cable joint 201 may be determined precisely.

Moreover, in the high-voltage operation environment, sometimes the induced voltage at the adaptor 101 can reach a level up to several hundred volts or the change in the induced voltage could be quite fast, which may affect the operation of the temperature sensor 102 and its connected processing circuitry 103 designed to be operated in a low-voltage environment. Therefore, in various embodiments of the present disclosure, the processing circuitry 103 is also electrically shielded from the voltage of the adaptor 101, so as to reduce the impact of the several hundred voltages to processing circuitry 103.

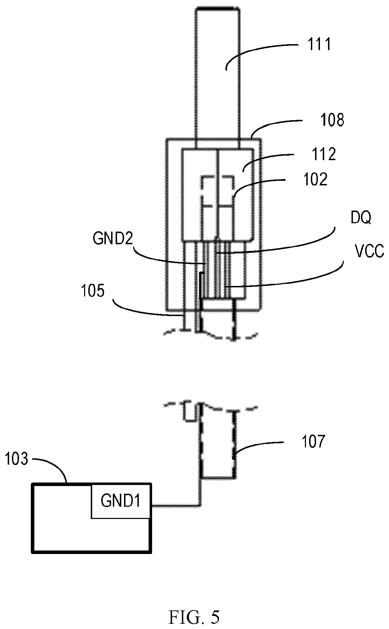

Fig. 5 illustrates a shielding mechanism according to the present invention. As illustrated in Fig. 5, according to the present invention, in order to electrically shield the processing circuitry 103 from the detected voltage of the adaptor 101, the ground terminal GND1 of the processing circuitry 103, the adaptor 101, and the ground terminal GND2 of the temperature sensor 102 are coupled to each other. In this way, the temperature sensor 102, the adaptor 101, and the temperature sensor 102 will always share a same "floating" grounding potential. Therefore, any high-voltage change possibly occur at the adaptor 101 will not affect the operation of the processing circuitry 103.

In addition, a shielding layer 107 may be provided to surround all wires between the temperature sensor 102 and the processing circuitry 103. For instance, for those typical temperature sensors (such as, DS18B20) having three wires, namely, the ground wire (such as "GND2" in Fig. 5), power supply wire (such as "VCC" in Fig. 5), and the signal wire (such as "DQ" in Fig. 5), the additional shielding layer 107 (for example, in a form of a metallic mesh structure) may arranged to surround all three wires.

In the meantime, as further illustrated in Fig.5, the shielding layer 107 is also coupled to the ground terminal GND2 of the temperature sensor 102. In other words, the ground terminal GND1 of the processing circuitry 103, the adaptor 101, the ground terminal GND2, and the shielding layer now are all connected together, which forms an equipotential grounding.

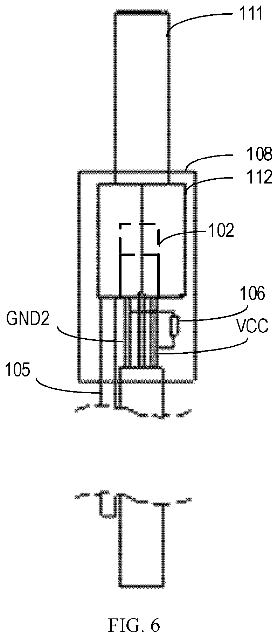

Fig. 6 illustrates another example shielding mechanism according to an embodiment of the present disclosure. As illustrated in Fig. 6, in some embodiments, in order to electrically shield the processing circuitry 103 from the detected voltage of the adaptor 101, a transient voltage suppressor 106 may be additionally provided and coupled between the ground terminal GND2 and a power supply VCC of the temperature sensor 102. In this way, the voltage difference between the ground terminal GND2 and the power supply VCC of the temperature sensor 102 will be clamped. Thereby, avoiding the breakdown of the processing circuitry 103.

Additionally, as illustrated in Fig. 5 and Fig. 6, a rubber coating layer 108 can be arranged outside the joint 101 to provide insulation and wiring fixing. In other words, with the coating layer 108, the transient voltage suppressor 106 and the wires from the temperature sensor 102 can be isolated from the environment.

In some embodiments, the adaptor 101 as illustrated in Fig. 5 and Fig. 6 may comprise a first part 111 and a second part 112. The first part 111 is coupled to the cable socket 31 at the mounting surface 312, and the second part 112 is used to accommodate the temperature sensor 102 and a connecting port 105 for the voltage indicating device 104.

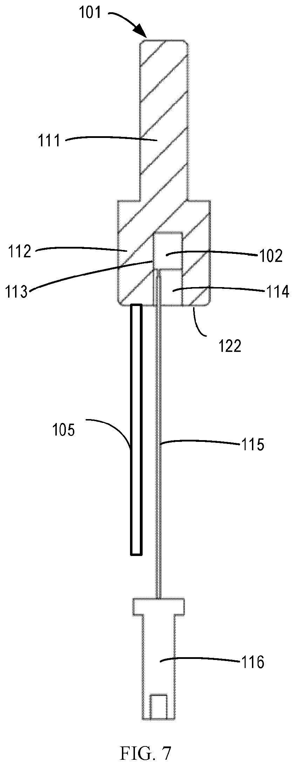

Fig. 7 illustrates a cross-sectional view of the adaptor 101 accommodating the temperature sensor 102 and the connecting port 105 for the voltage indicating device 104. In this example, the second part 112 may comprise a receiving hole 113 in which the temperature sensor 102 are arranged (for example, inserted) and sealed by pouring sealant 114. The temperature sensor 102 may be connected to the processor 103 through a wire 115 and a terminal 116. A value of the detected temperature of the adaptor 101 may be provided to the processor 103 via the wire 115 and the terminal 116. Further, the second part 112 also comprises an end surface 122 for coupling the connecting port 105 to the adaptor 101 via a conductive connection.

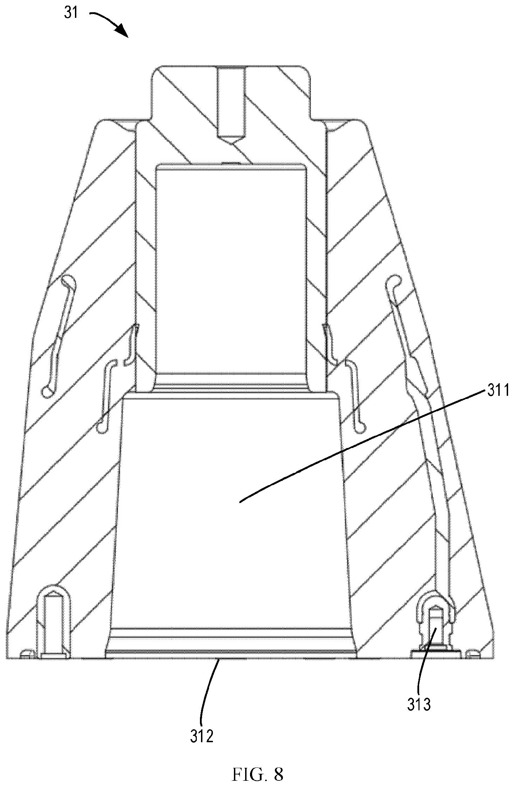

Fig. 8 illustrates a cross-sectional view of the cable socket 31 as shown in Fig. 3, but with no adaptor 101 attached. As shown in Fig. 8, in some embodiments, the cable socket 31 may comprise a threaded hole 313 at the mounting surface 312. Correspondingly, the first part 111 may be a threaded rot adapted to be inserted into the threaded hole 313. It is to be noted that such threaded hole 313 may also be arranged on the mounting surface 312 at the cable socket 31 as illustrated in Fig. 4. Through thread mating between the threaded rot and the threaded hole 313, the first part 111 may be screwed into or out of the threaded hole 313. In this way, the apparatus 100 is easy to be installed and maintained.

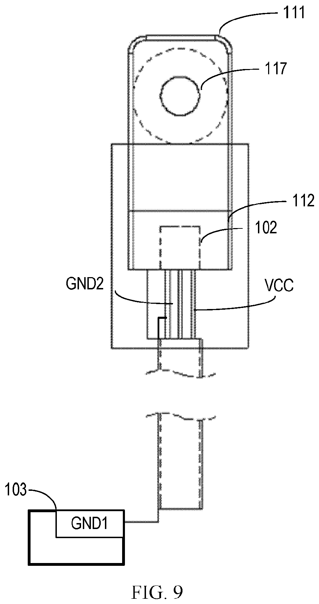

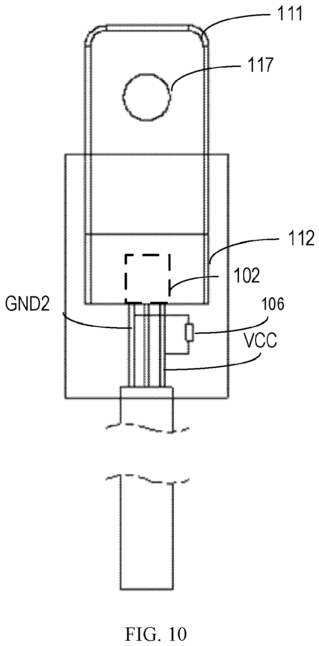

Fig. 9 and Fig. 10 illustrate a different type of adaptor according to an embodiment of the disclosure. Fig. 9 and 10 respectively show a same electric shielding mechanism as those adopted in Figs. 4 and 5. Thus, the principle of electric shielding mechanism will not be repeated here.

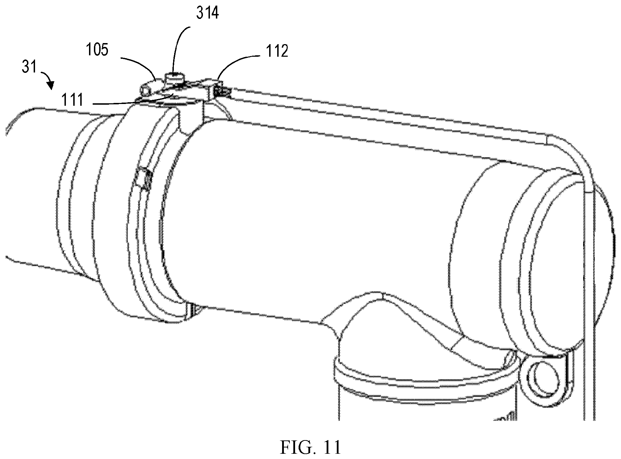

One of the two differences between Figs. 9-10 and Fig. 4-5 lies in the form of the adaptor 101. In this example, the cable socket 31 may comprise a protrusion 314 at the mounting surface 312 (Fig. 11). Correspondingly, the first part 111 of the adaptor 101 may comprise a mounting hole 117 to fit the protrusion 314 in order to achieve the conductive connection, which provides another possible way to conveniently install the apparatus 100 onto the cable socket 31.

The other difference lies in that the connecting port 105 for the voltage indicating device 104 as shown in Fig. 4-5 does not coupled to the second part 112 of the adaptor 101. Instead, the connecting port 105 may be separately attached to the protrusion 314 as shown in Fig. 11, which enhances the design flexibility.

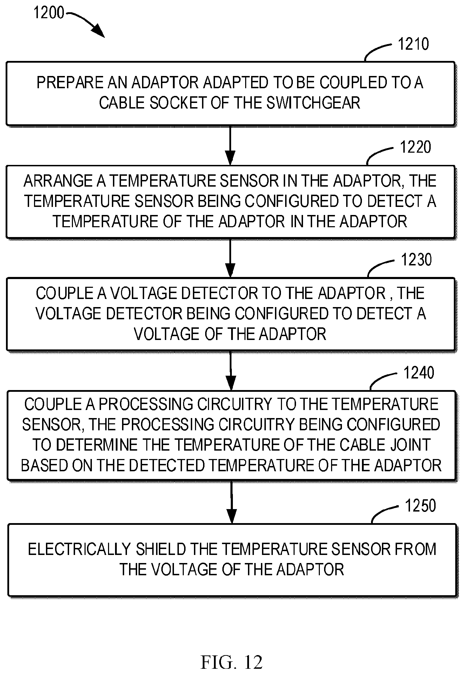

Fig. 12 is a flow chart of a method 1200 for manufacturing the apparatus 100 according to the present invention. The method 1200 will be described with reference to the apparatus 100 that has been described above with reference to Fig. 1-11.

At block 1210, an adaptor 101 adapted to be coupled to a cable socket 31 of the switchgear 300 is prepared. At block 1220, a temperature sensor 102 is arranged in the adaptor 101, the temperature sensor 102 being configured to detect a temperature of the adaptor 101 in the adaptor 101. At block 1230, a voltage detector 104 is coupled to the adaptor 101, the voltage detector 104 being configured to detect a voltage of the adaptor 101. At block 1240, a processing circuitry 103 is coupled to the temperature sensor 102, the processing circuitry 103 being configured to determine the temperature of the cable joint 201 based on the detected temperature of the adaptor 101. At block 1250, the temperature sensor 102 is electrically shielded from the voltage of the adaptor 101.

According to the present invention, the electrically shielding the temperature sensor 102 (block 1250) comprises: coupling a ground terminal GND1 of the processing circuitry 103, the adaptor 101, and a ground terminal GND2 of the temperature sensor 102 to each other.

In some embodiments, method 1200 may further comprises: surrounding, by a shielding layer, wires between the temperature sensor 102 and the processing circuitry 103, and coupling the shielding layer to the ground terminal GND2 of the temperature sensor 102.

In some embodiments, the electrically shielding the processing circuitry 103 may comprise: coupling a transient voltage suppressor 106 between the ground terminal GND2 of the temperature sensor 102 and a power supply VCC of the temperature sensor 102.

In some embodiments, the adaptor 101 may comprises: a first part 111 coupled to the cable socket 31 at the mounting surface 312; and a second part 112 adapted to accommodate the temperature sensor 102 and a connecting port 105 to the voltage indicating device 104.

In some embodiments, the second part 112 may comprise a receiving hole 113, wherein the method 1200 further comprises arranging the temperature sensor 102 in the receiving hole 13; sealing the receiving hole 13 by pouring sealant 114; and coupling the connecting port 105 to an end surface 122 of the second part 112.

## Claims

1. An apparatus (100) for monitoring a temperature and a voltage of a cable joint (201) of a cable (200) connected to a gas insulated switchgear (300), comprising:
an adaptor (101) adapted to be coupled to a cable socket (31) of the switchgear (300),
a voltage detector (104) coupled to the adaptor (101) and configured to detect a voltage of the adaptor (101);
a temperature sensor (102) arranged in the adaptor (101) and configured to detect a temperature of the adaptor (101);
a processing circuitry (103) configured to determine the temperature of the cable joint (201) based on the detected temperature of the adaptor (101);
a ground terminal (GND2) of the temperature sensor (102) being coupled to a ground terminal (GND1) of the processing circuitry (103), so as to electrically shield the processing circuitry (103) from the voltage of the adaptor (101);
wherein the ground terminal (GND1) of the processing circuitry (103), the adaptor (101), and the ground terminal (GND2) of the temperature sensor (102) are coupled to each other to electrically shield the processing circuitry (103) from the detected voltage of the adaptor (101).

2. The apparatus (100) according to claim 1, further comprising:
a shielding layer surrounding wires between the temperature sensor (102) and the processing circuitry (103), the shielding layer being coupled to the ground terminal (GND2) of the temperature sensor (102).

3. The apparatus (100) according to claim 1, further comprising:
a transient voltage suppressor (106) coupled between the ground terminal (GND2) of the temperature sensor (102) and a power supply (VCC) of the temperature sensor (102) to electrically shield the processing circuitry (103) from the detected voltage of the adaptor (101).

4. The apparatus (100) according to claim 1, wherein the adaptor (101), when coupled to the cable socket (31), is situated at a mounting surface (312) outside the cable socket (31).

5. The apparatus (100) according to claim 4, wherein the adaptor (101) comprises:
a first part (111) coupled to the cable socket (31) at the mounting surface (312); and
a second part (112) adapted to accommodate the temperature sensor (102) and a connecting port (105) to the voltage indicating device (104).

6. The apparatus (100) according to claim 5, wherein the cable socket (31) comprises a threaded hole (313) at the mounting surface (312), and the first part (111) is a threaded rot adapted to be inserted into the threaded hole (313).

7. The apparatus (100) according to claim 5, wherein the second part (112) comprises a receiving hole (113) in which the temperature sensor (102) is arranged and sealed by pouring sealant (114), and an end surface (122) to couple the connecting port (105).

8. A method for manufacturing an apparatus (100) for monitoring a temperature and a voltage of a cable joint (201) of a cable (200) connected to a gas insulated switchgear (300), comprising:
preparing an adaptor (101) adapted to be coupled to a cable socket (31) of the switchgear (300);
arranging a temperature sensor (102) in the adaptor (101), the temperature sensor (102) being configured to detect a temperature of the adaptor (101) in the adaptor (101);
coupling a voltage detector (104) to the adaptor (101), the voltage detector (104) being configured to detect a voltage of the adaptor (101),;
coupling a processing circuitry (103) to the temperature sensor (102), the processing circuitry (103) being configured to determine the temperature of the cable joint (201) based on the detected temperature of the adaptor (101); and
coupling a ground terminal (GND2) of the temperature sensor (102) to a ground terminal (GND1) of the processing circuitry (103), so as to electrically shield the processing circuitry (103) from the voltage of the adaptor (101);
wherein the electrically shielding the processing circuitry (103) comprises
coupling the ground terminal (GND1) of the processing circuitry (103), the adaptor (101), and the ground terminal (GND2) of the temperature sensor (102) to each other.

9. The method according to claim 8, further comprising:
surrounding, by a shielding layer, wires between the temperature sensor (102) and the processing circuitry (103); and
coupling the shielding layer to the ground terminal (GND2) of the temperature sensor (102).

10. The method according to claim 11, wherein the electrically shielding the processing circuitry (103) comprises:
coupling a transient voltage suppressor (106) between the ground terminal (GND2) of the temperature sensor (102) and a power supply (VCC) of the temperature sensor (102).

11. The method according to claim 10, wherein the adaptor (101) comprises:
a first part (111) coupled to the cable socket (31) at the mounting surface (312); and
a second part (112) adapted to accommodate the temperature sensor (102) and a connecting port (105) to the voltage indicating device (104).

12. The method according to claim 11, wherein the second part (112) comprises a receiving hole (113), wherein the method further comprises
arranging the temperature sensor (102) in the receiving hole (13);
sealing the receiving hole (13) by pouring sealant (114); and
coupling the connecting port (105) to an end surface (122) of the second part (112).

13. A gas insulated switchgear (300) comprising the apparatus (100) according to any of claims 1-7.

## Patentansprüche

1. Vorrichtung (100) zur Überwachung einer Temperatur und einer Spannung einer Kabelverbindung (201) eines mit einer gasisolierten Schaltanlage (300) verbundenen Kabels (200), umfassend:
einen Adapter (101), der mit einer Kabeldose (31) der Schaltanlage (300) gekoppelt werden kann,
einen Spannungsdetektor (104), der mit dem Adapter (101) gekoppelt und so konfiguriert ist, dass er eine Spannung des Adapters (101) erfasst;
einen Temperatursensor (102), der in dem Adapter (101) angeordnet und so konfiguriert ist, dass er eine Temperatur des Adapters (101) erfasst;
einen Verarbeitungsschaltkreises (103), der so konfiguriert ist, dass er die Temperatur der Kabelverbindung (201) auf der Grundlage der erfassten Temperatur des Adapters (101) bestimmt;
einen Erdungsanschluss (GND2) des Temperatursensors (102), der mit einem Erdungsanschluss (GND1) des Verarbeitungsschaltkreises (103) gekoppelt ist, um den Verarbeitungsschaltkreis (103) von der Spannung des Adapters (101) elektrisch abzuschirmen;
wobei der Erdungsanschluss (GND1) des Verarbeitungsschaltkreises (103), der Adapter (101) und der Erdungsanschluss (GND2) des Temperatursensors (102) miteinander gekoppelt sind, um den Verarbeitungsschaltkreis (103) von der erfassten Spannung des Adapters (101) elektrisch abzuschirmen.

2. Vorrichtung (100) nach Anspruch 1, ferner umfassend:
eine Abschirmschicht, die die Drähte zwischen dem Temperatursensor (102) und den Verarbeitungsschaltkreis (103) umgibt, wobei die Abschirmschicht mit dem Erdungsanschluss (GND2) des Temperatursensors (102) verbunden ist.

3. Vorrichtung (100) nach Anspruch 1, ferner umfassend:
einen Transienten-Spannungsunterdrücker (106), der zwischen den Erdungsanschluss (GND2) des Temperatursensors (102) und eine Stromversorgung (VCC) des Temperatursensors (102) geschaltet ist, um den Verarbeitungsschaltkreis (103) elektrisch von der erfassten Spannung des Adapters (101) abzuschirmen.

4. Vorrichtung (100) nach Anspruch 1, wobei der Adapter (101), wenn er mit der Kabelbuchse (31) verbunden ist, an einer Montagefläche (312) außerhalb der Kabelbuchse (31) angeordnet ist.

5. Vorrichtung (100) nach Anspruch 4, wobei der Adapter (101) umfasst:
einen ersten Teil (111), der mit der Kabelbuchse (31) an der Montagefläche (312) verbunden ist; und
einen zweiten Teil (112), der zur Aufnahme des Temperatursensors (102) geeignet ist, und einen Verbindungsanschluss (105) zur Spannungsanzeigevorrichtung (104).

6. Vorrichtung (100) nach Anspruch 5, wobei die Kabelbuchse (31) ein Gewindeloch (313) an der Montagefläche (312) aufweist und der erste Teil (111) ein Gewindestab ist, der in das Gewindeloch (313) eingesetzt werden kann.

7. Vorrichtung (100) nach Anspruch 5, wobei der zweite Teil (112) ein Aufnahmeloch (113), in dem der Temperatursensor (102) angeordnet und durch Ausgießen von Dichtungsmasse (114) abgedichtet ist, und eine Endfläche (122) zum Koppeln des Anschlusses (105) umfasst.

8. Verfahren zur Herstellung einer Vorrichtung (100) zur Überwachung einer Temperatur und einer Spannung einer Kabelverbindung (201) eines Kabels (200), das mit einer gasisolierten Schaltanlage (300) verbunden ist, umfassend:
Herstellen eines Adapters (101), der mit einer Kabeldose (31) der Schaltanlage (300) verbunden werden kann;
Anordnen eines Temperatursensors (102) in dem Adapter (101), wobei der Temperatursensor (102) so konfiguriert ist, dass er eine Temperatur des Adapters (101) in dem Adapter (101) erfasst;
Koppeln eines Spannungsdetektors (104) mit dem Adapter (101), wobei der Spannungsdetektor (104) so konfiguriert ist, dass er eine Spannung des Adapters (101) erfasst,;
Koppeln eines Verarbeitungsschaltkreises (103) mit dem Temperatursensor (102), wobei der Verarbeitungsschaltkreis (103) so konfiguriert ist, dass er die Temperatur der Kabelverbindung (201) auf der Grundlage der erfassten Temperatur des Adapters (101) bestimmt; und
Koppeln eines Erdungsanschlusses (GND2) des Temperatursensors (102) mit einem Erdungsanschluss (GND1) des Verarbeitungsschaltkreises (103), um den Verarbeitungsschaltkreis (103) von der Spannung des Adapters (101) elektrisch abzuschirmen;
wobei die elektrische Abschirmung des Verarbeitungsschaltkreises (103) umfasst
das Koppeln des Erdungsanschluss (GND1) des Verarbeitungsschaltkreises (103), des Adapters (101) und des Erdungsanschluss (GND2) des Temperatursensors (102) miteinander.

9. Verfahren nach Anspruch 8, ferner umfassend:
Umgeben, durch eine Abschirmschicht, von Drähten zwischen dem Temperatursensor (102) und dem Verarbeitungsschaltkreis (103); und
Koppeln der Abschirmungsschicht mit dem Erdungsanschluss (GND2) des Temperatursensors (102).

10. Verfahren nach Anspruch 11, wobei die elektrische Abschirmung des Verarbeitungsschaltkreises (103) umfasst:
Koppeln eines Transienten-Spannungsunterdrückers (106) zwischen dem Erdungsanschluss (GND2) des Temperatursensors (102) und einer Stromversorgung (VCC) des Temperatursensors (102).

11. Verfahren nach Anspruch 10, wobei der Adapter (101) umfasst:
einen ersten Teil (111), der mit der Kabelbuchse (31) an der Montagefläche (312) verbunden ist; und
einen zweiten Teil (112), der zur Aufnahme des Temperatursensors (102) geeignet ist, und eine Verbindungsöffnung (105) zur Spannungsanzeigevorrichtung (104).

12. Verfahren nach Anspruch 11, wobei der zweite Teil (112) ein Aufnahmeloch (113) umfasst, wobei das Verfahren ferner umfasst
Anordnen des Temperatursensors (102) in dem Aufnahmeloch (13);
Abdichten des Aufnahmelochs (13) durch Ausgießen von Dichtungsmasse (114); und
Koppeln des Verbindungsanschlusses (105) mit einer Endfläche (122) des zweiten Teils (112).

13. Gasisolierte Schaltanlage (300), umfassend die Vorrichtung (100) nach einem der Ansprüche 1-7.

## Revendications

1. Appareil (100) pour surveiller une température et une tension d'une jonction de câble (201) d'un câble (200) connecté à un appareillage de commutation isolé par gaz (300), comprenant :
un adaptateur (101) adapté pour être couplé à une prise de câble (31) de l'appareillage de commutation (300),
un détecteur de tension (104) couplé à l'adaptateur (101) et configuré pour détecter une tension de l'adaptateur (101) ;
un capteur de température (102) agencé dans l'adaptateur (101) et configuré pour détecter une température de l'adaptateur (101) ;
une circuiterie de traitement (103) configurée pour déterminer la température de la jonction de câble (201) sur la base de la température détectée de l'adaptateur (101) ;
une borne de mise à la terre (GND2) du capteur de température (102) étant couplée à une borne de mise à la terre (GND1) de la circuiterie de traitement (103), afin de protéger électriquement la circuiterie de traitement (103) de la tension de l'adaptateur (101) ;
dans lequel la borne de mise à la terre (GND1) de la circuiterie de traitement (103), l'adaptateur (101), et la borne de mise à la terre (GND2) du capteur de température (102) sont couplés les uns aux autres pour protéger électriquement la circuiterie de traitement (103) de la tension détectée de l'adaptateur (101).

2. Appareil (100) selon la revendication 1, comprenant en outre :
une couche de protection fournie autour de fils entre le capteur de température (102) et la circuiterie de traitement (103), la couche de protection étant couplée à la borne de mise à la terre (GND2) du capteur de température (102).

3. Appareil (100) selon la revendication 1, comprenant en outre :
un suppresseur de tension transitoire (106) couplé entre la borne de mise à la terre (GND2) du capteur de température (102) et une alimentation électrique (VCC) du capteur de température (102) pour protéger électriquement la circuiterie de traitement (103) de la tension détectée de l'adaptateur (101).

4. Appareil (100) selon la revendication 1, dans lequel l'adaptateur (101), lorsqu'il est couplé à la prise de câble (31), est situé au niveau d'une surface de montage (312) à l'extérieur de la prise de câble (31) .

5. Appareil (100) selon la revendication 4, dans lequel l'adaptateur (101) comprend :
une première partie (111) couplée à la prise de câble (31) au niveau de la surface de montage (312) ; et une seconde partie (112) adaptée pour loger le capteur de température (102) et un port de connexion (105) au dispositif d'indication de tension (104).

6. Appareil (100) selon la revendication 5, dans lequel la prise de câble (31) comprend un trou fileté (313) au niveau de la surface de montage (312), et la première partie (111) est une tige filetée adaptée pour être insérée dans le trou fileté (313).

7. Appareil (100) selon la revendication 5, dans lequel la seconde partie (112) comprend un trou de réception (113) dans lequel le capteur de température (102) est agencé et étanchéifié en versant un produit d'étanchéité (114), et une surface d'extrémité (122) pour coupler le port de connexion (105).

8. Procédé pour fabriquer un appareil (100) pour surveiller une température et une tension d'une jonction de câble (201) d'un câble (200) connecté à un appareillage de commutation isolé par gaz (300), comprenant :
la préparation d'un adaptateur (101) adapté pour être couplé à une prise de câble (31) de l'appareillage de commutation (300) ;
l'agencement d'un capteur de température (102) dans l'adaptateur (101), le capteur de température (102) étant configuré pour détecter une température de l'adaptateur (101) dans l'adaptateur (101) ;
le couplage d'un détecteur de tension (104) à l'adaptateur (101), le détecteur de tension (104) étant configuré pour détecter une tension de l'adaptateur (101) ;
le couplage d'une circuiterie de traitement (103) au capteur de température (102), la circuiterie de traitement (103) étant configurée pour déterminer la température de la jonction de câble (201) sur la base de la température détectée de l'adaptateur (101) ; et
le couplage d'une borne de mise à la terre (GND2) du capteur de température (102) à une borne de mise à la terre (GND1) de la circuiterie de traitement (103), afin de protéger électriquement la circuiterie de traitement (103) de la tension de l'adaptateur (101) ;
dans lequel la protection électrique de la circuiterie de traitement (103) comprend
le couplage de la borne de mise à la terre (GND1) de la circuiterie de traitement (103), de l'adaptateur (101), et de la borne de mise à la terre (GND2) du capteur de température (102) les uns aux autres.

9. Procédé selon la revendication 8, comprenant en outre :
la fourniture d'une couche de protection autour de fils entre le capteur de température (102) et la circuiterie de traitement (103) ; et
le couplage de la couche de protection à la borne de mise à la terre (GND2) du capteur de température (102).

10. Procédé selon la revendication 11, dans lequel la protection électrique de la circuiterie de traitement (103) comprend :
le couplage d'un suppresseur de tension transitoire (106) entre la borne de mise à la terre (GND2) du capteur de température (102) et une alimentation électrique (VCC) du capteur de température (102).

11. Procédé selon la revendication 10, dans lequel l'adaptateur (101) comprend :
une première partie (111) couplée à la prise de câble (31) au niveau de la surface de montage (312) ; et une seconde partie (112) adaptée pour loger le capteur de température (102) et un port de connexion (105) au dispositif d'indication de tension (104).

12. Procédé selon la revendication 11, dans lequel la seconde partie (112) comprend un trou de réception (113), dans lequel le procédé comprend en outre
l'agencement du capteur de température (102) dans le trou de réception (13) ;
l'étanchéification du trou de réception (13) en versant un produit d'étanchéité (114) ; et
le couplage du port de connexion (105) à une surface d'extrémité (122) de la seconde partie (112).

13. Appareillage de commutation isolé par gaz (300) comprenant l'appareil (100) selon l'une quelconque des revendications 1 à 7.
